# EUROPÄISCHE PATENTANMELDUNG

(11) **EP 2 088 251 A2**
(43) Veröffentlichungstag der Anmeldung: **12.08.2009**
(21) Anmeldenummer: 09152479.3
(22) Anmeldetag: 10.02.2009
(51) Int. Cl.: E03D 5/10, H03K 17/26

(54) **Vorrichtung zur elektrischen Auslösung eines Spülvorgangs in einer sanitären Einrichtung**

(30) Priorität: 11.02.2008 DE 202008001913 U
(71) Anmelder: Viega GmbH & Co. KG, 57439 Attendorn (DE)
(72) Erfinder: Droste, Stefan, 57439 Attendorn (DE); Kuhbier, Ulrich, 58849 Herscheid (DE); Wessel, Heinz-Werner, 58840 Plettenberg (DE)
(74) Vertreter: Cohausz & Florack

(57) **Zusammenfassung**

Die Erfindung betrifft eine Vorrichtung zur elektrischen Auslösung eines Spülvorgangs in einer sanitären Einrichtung, insbesondere in einem WC oder Urinal, mit einer Betätigungsplatte (2) aus Glas oder aus einem anderen elektrisch nioht-leitfähigem Material, wobei die Betätigungsplatte (2) mindestens eine Sensortaste aufweist, die an einer Steuerung (4) zur Betätigung eines Ablauf- oder Wasserventils angeschlossen ist. Um die Betätigungsplatte (2) reinigen zu können, ohne dass durch die Reinigung ungewollt Spülvorgänge ausgelöst werden, ist die Betätigungsplatte (2) erfindungsgemäß mit mindestens einem berührungslos betätigbaren Schalter (4.3) versehen, mittels dem die Sensortaste oder die Steuerung (4) deaktivierbar ist.

## Beschreibung

Die Erfindung betrifft eine Vorrichtung zur elektrischen Auslösung eines Spülvorgangs in einer sanitären Einrichtung, insbesondere in einem WC oder Urinal, mit einer Betätigungsplatte aus Glas oder einem anderen elektrisch nicht-leitfähigem Material, wobei die Betätigungsplatte mindestens eine Sensortaste aufweist, die an einer Steuerung zur Betätigung eines Ablauf- oder Wasserventils angeschlossen ist.

Herkömmliche Betätigungsplatten zur Auslösung eines WC-Spülvorgangs funktionieren rein mechanisch. Sie weisen üblicherweise eine oder zwei Betätigungstasten auf, die beweglich, meist schwenkbar gelagert sind.

Ferner sind auch Vorrichtungen zur Auslösung einer WC-Spülung bekannt, die einen oder mehrere elektrische Betätigungsschalter aufweisen.

Aus der DE 31 40 307 A1 ist eine Steuereinrichtung zur elektrischen Auslösung eines mit einer elektromagnetischen Betätigungsvorrichtung versehenen Spülkastenventils bekannt, die eine kapazitive Sensortaste aufweist. Die Sensortaste ist aus einer aus Glaskeramik bestehenden Platte gebildet, die auf ihren beiden Seiten mit Metallbeschichtungen als Kondensatorplatten versehen ist. Die Vorderseite der Glasplatte ist dabei mit zwei Tastfeldern zur Auslösung einer Teilspülung oder Vollspülung versehen, während auf der Rückseite der Glasplatte gegenüber jeder als Tastfeld dienenden Metallbeschichtung zwei voneinander getrennte Metallbeschichtungen angebracht sind. An der Sensortaste ist eine elektronische Auswerteschaltung angeschlossen, die in Abhängigkeit von einer momentanen Berührung eines der Tastenfelder ein entsprechendes Ausgangssignal abgibt. An der Auswerteschaltung ist wiederum eine Steuerschaltung angeschlossen, welche je ein jedem Tastfeld der Sensortaste zugeordnetes Zeitglied aufweist und welche bei Erhalt des Ausgangssignals der Auswerteschaltung ein Steuersignal abgibt, dessen zeitliche Länge durch das betreffende Zeitglied bestimmt. Die Glasplatte ist an einer eine Wandöffnung abdeckenden Revisionsplatte (Abdeckplatte) angeschraubt, wobei die Revisionsplatte ihrerseits mittels Schrauben an dem in der Wand integrierten Unterputz-Spülkasten befestigt ist. Die Glasplatte sowie die Revisionsplatte weisen hierzu jeweils von der Vorderseite zugängliche Durchgangslöcher zur Aufnahme der Schrauben auf.

Diese bekannte Steuereinrichtung ist in verschiedener Hinsicht unbefriedigend. So werden bei jeder Reinigung der Tastenfelder mit einem Reinigungstuch oder dergleichen unnötiger Weise eine oder mehrere Spülungen ausgelöst. Ferner ist die Herstellung dieser Steuereinrichtung insbesondere aufgrund der für das Aufbringen der Metallbeschichtungen erforderlichen Arbeitsschritte relativ aufwendig. Zudem ist diese Steuereinrichtung in hygienischer Hinsicht verbesserungsbedürftig. Denn an den Durchgangslöchern zur Aufnahme der Schrauben sowie an den Rändern der Metallbeschichtungen auf der Vorderseite der Glasplatte können anhaftende Bakterien- und Schmutzanlagerungen kaum oder nur schwierig entfernt werden.

Der vorliegenden Erfindung liegt die Aufgabe zugrunde, eine Vorrichtung der eingangs genannten Art zu schaffen, bei der ungewollte, durch Reinigung der Betätigungsplatte ausgelöste Spülvorgänge verhindert werden können.

Diese Aufgabe wird erfindungsgemäß durch eine Vorrichtung mit den Merkmalen des Anspruchs 1 gelöst.

Erfindungsgemäß ist die Betätigungsplatte mit mindestens einem berührungslos betätigbaren Schalter versehen, mittels dem die Sensortaste(n) oder die Steuerung deaktivierbar ist.

Der Schalter kann dabei beispielsweise als Ein-Aus-Schalter ausgeführt sein, so dass die Sensortaste oder die Steuerung deaktivierbar ist und eine solche Deaktivierung unverzüglich wieder aufgehoben werden kann. Der Benutzer kann somit vor einer Reinigung der Betätigungsplatte durch Betätigung des Ein-Aus-Schalters die Funktion der mindestens einen Sensortaste bzw. der Steuerung sperren, um beim Reinigen der Betätigungsplatte insbesondere im Bereich der Sensortaste eine ungewollte Auslösung eines Spülvorgangs zu verhindern. Nach durchgeführter Reinigung kann der Benutzer die Sperrung der Funktion durch erneute Betätigung des Ein-Aus-Schalters aufheben, so dass bei Bedarf ein Spülvorgang wieder ausgelöst werden kann. Der Benutzer bestimmt in diesem Fall selbst den Zeitpunkt der Aufhebung einer Deaktivierung der Sensortaste bzw. der Steuerung.

Nach einer anderen Ausgestaltung der Erfindung ist vorgesehen, dass dem Schalter ein Zeitglied zugeordnet ist, welches nach Ablauf einer vorgegebenen oder vorgebbaren Zeitspanne die durch Betätigung des Schalters bewirkte Deaktivierung der Sensortaste und/oder der Steuerung aufhebt. In diesem Fall wird die vom Anwender durch Betätigung des Schalters vorgenommene Deaktivierung der Sensortaste bzw. der Steuerung nach Ablauf der Zeitspanne automatisch aufgehoben.

Eine weitere bevorzugte Ausgestaltung der erfindungsgemäßen Vorrichtung ist dadurch gekennzeichnet, dass dem Schalter ein Signalgeber zugeordnet ist, der während der Deaktivierung der Sensortaste(n) oder der Steuerung ein akustisches und/oder optisches Signal abgibt.

Ein Benutzer der Betätigungsplatte wird somit auf eine Deaktivierung der Sensortaste(n) oder der Steuerung hingewiesen, so dass eine Aufhebung der Deaktivierung nach durchgeführter Reinigung der Betätigungsplatte nicht vergessen wird bzw. bei Einsatz des oben genannten Zeitgliedes abgewartet wird bis die Funktionssperrung (Deaktivierung) automatisch aufgehoben wird.

Der Schalter ist vorzugsweise an der Hinterseite der Betätigungsplatte angeordnet, so dass er für einen Benutzer im montierten Zustand der Betätigungsplatte nicht sichtbar ist. Die Position des Schalters kann jedoch durch ein Symbol auf der Vorderseite der Betätigungsplatte markiert oder in einer zu der Vorrichtung mitgelieferten Bedienungsanleitung vermerkt sein. Beispielsweise kann der Schalter hinter einem auf der Vorderseite der Betätigungsplatte angebrachten Firmenlogo oder dergleichen angeordnet sein.

Der Schalter zur Sperrung der Funktion der Sensortaste(n) oder der Steuerung ist vorzugsweise als magnetischer Näherungsschalter ausgeführt, der berührungslos mittels eines Magneten betätigbar ist. Besonders bevorzugt wird hierzu ein Reed-Schalter verwendet.

Der Reed-Schalter weist zwei, durch einen Spalt getrennte, federnde Kontaktzungen aus weichmagnetischem Material auf, die in einem hermetisch geschlossenen Hohlkörper bzw. Glasröhrchen angeordnet sind. Reed-Schalter sind daher im Wesentlichen unabhängig von atmosphärischen Einflüssen - wie etwa feuchter Umgebungsluft - und somit besonders funktionssicher. Unter Einwirkung eines äußeren Magnetfeldes berühren sich die Kontaktzungen und stellen einen elektrischen Kontakt her. Die Betätigung des Reed-Schalters erfolgt mittels eines Magnetschlüssels oder dergleichen.

Vorzugsweise ist der Näherungsschalter bzw. Reed-Schalter der erfindungsgemäßen Vorrichtung mit einer Leuchtdiode versehen, die seinen Schaltzustand anzeigt.

In einer weiteren bevorzugten Ausgestaltung umfasst die erfindungsgemäße Vorrichtung einen Grundrahmen zu ihrer Befestigung an einer Revisionsöffnung oder Wandöffnung, wobei die Betätigungsplatte im montierten Zustand die Revisionsöffnung bzw. Wandöffnung abdeckt. Die Sensortaste ist vorzugsweise ausschließlich auf der Rückseite der Betätigungsplatte angeordnet. Die Vorderseite der Betätigungsplatte ist fugenlos sowie ohne sonstigen Durchbruch ausgebildet. Zu ihrer Befestigung weist die Betätigungsplatte rückseitig mindestens ein mit dem Grundrahmen lösbar verbindbares Befestigungselement auf. Im montierten Zustand deckt die Betätigungsplatte die Vorderseite des Grundrahmens vollständig ab.

Die erfindungsgemäße Vorrichtung bietet durch die mindestens eine Sensortaste eine komfortable WC-Betätigung. Wenn die Sensortaste nur auf der Rückseite der Betätigungsplatte angeordnet ist und die Vorderseite der Betätigungsplatte keine Fugen oder sonstige Durchbrüche aufweist, ergibt sich eine einfach zu reinigende Oberfläche. Vorzugsweise ist die Betätigungsplatte aus Glas gefertigt, das in hygienischer Hinsicht eine optimale Oberfläche darstellt. Im Gegensatz zu der mit Metallbeschichtungen und Befestigungslöchern versehenen Glasplatte der Steuereinrichtung gemäß der DE 31 40 307 A1 erfordert die Betätigungsplatte der erfindungsgemäßen Vorrichtung keine zusätzlichen Bearbeitungsschritte.

Die mindestens eine Sensortaste sowie die zugehörige Steuerung werden vorzugsweise rückseitig auf die Betätigungsplatte (Glasplatte) aufgeklebt. Durch das an der Rückseite der Betätigungsplatte ebenfalls vorgesehene Befestigungselement lässt sich die Betätigungsplatte dann einfach und bequem an dem an der Wandöffnung vor der Revisionsöffnung angebrachten Grundrahmen montieren und bei Bedarf demontieren.

Um eine einfache und zuverlässige Montage der Betätigungsplatte (Glasplatte) an dem Grundrahmen zu ermöglichen, ist das Befestigungselement in einer bevorzugten Ausgestaltung der erfindungsgemäßen Vorrichtung als in den Grundrahmen einsetzbarer Befestigungsrahmen ausgebildet. Der Befestigungsrahmen und/oder der Grundrahmen sind dabei vorzugsweise mit einteilig angeformten Clipelementen versehen, die zur Verrastung in zugeordnete Durchbrüche oder Ausnehmungen des Grundrahmens bzw. Befestigungsrahmens einsteckbar sind.

In einer weiteren bevorzugten Ausgestaltung weist der Grundrahmen an seiner Vorderseite einen Flansch zur Anlage an einen die Wandöffnung umgebenden Wandabschnitt auf. Der Grundrahmen oder zumindest der Flansch ist dabei vorzugsweise verchromt oder silberfarben ausgebildet.

Da die Betätigungsplatte im montierten Zustand die Vorderseite des Grundrahmens vollständig abdeckt, sind allenfalls die äußeren Schmalseiten des Flansches sichtbar. Die Betätigungsplatte ist vorzugsweise so bemessen, dass sie bündig mit den äußeren Schmalseiten des Flansches abschließt oder diese seitlich geringfügig überragt. Im montierten Zustand ist von der erfindungsgemäßen Vorrichtung somit im wesentlichen nur oder - bei entsprechend dünn ausgebildetem Flansch - nur die einteilige, ungelochte Betätigungsplatte sichtbar.

Weitere bevorzugte und vorteilhafte Ausgestaltungen der erfindungsgemäßen Vorrichtung sind in den Unteransprüchen angegeben.

Nachfolgend wird die Erfindung anhand mehrere Ausführungsbeispiele darstellenden Zeichnung näher erläutert. Es zeigen:
- Fig. 1: eine perspektivische Vorderansicht einer erfindungsgemäßen Vorrichtung zur elektrischen Auslösung eines Toiletten-Spülvorgangs;
- Fig. 2: eine perspektivische Rückansicht der Vorrichtung der Fig. 1;
- Fig. 3: eine Explosionsdarstellung der Vorrichtung der Fig. 1 in perspektivischer Vorderansicht;
- Fig. 4: eine Explosionsdarstellung der Vorrichtung der Fig. 1 in perspektivischer Rückansicht;
- Fig. 5: ein weiteres Ausführungsbeispiel einer Betätigungsplatte einer erfindungsgemäßen Vorrichtung mit einem Magnetschlüssel in Vorderansicht;
- Fig. 6: ein Rückansicht der Betätigungsplatte der Fig. 5;
- Fig. 7: eine Seitenansicht der Betätigungsplatte der Fig. 5; und
- Fig. 8: ein perspektivische Rückansicht der Betätigungsplatte der Fig. 5.

Die in der Zeichnung dargestellte Vorrichtung zur Auslösung einer Toilettenspülung umfasst einen Grundrahmen 1, eine Betätigungsplatte in Form einer Glasplatte 2, ein auf die Rückseite 2.2 der Glasplatte aufgeklebtes Befestigungselement 3 und eine Steuerung 4, die ebenfalls rückseitig auf die Glasplatte 2 aufgeklebt ist.

Die Glasplatte 2 besteht aus bruchfestem Sicherheitsglas oder Glaskeramik. Sie ist flach ausgebildet und besitzt eine ebene Vorderseite 2.1. Die Vorderseite 2.1 der Glasplatte ist vorzugsweise satiniert, wobei eine feine, durch Ätzen erzeugte Satinierung besonders bevorzugt ist. Die Dicke der Glasplatte 2 liegt beispielsweise im Bereich von 4 bis 8 mm.

Die einteilige Glasplatte 2 ist mit zwei Sensortasten (nicht gezeigt) versehen, bei denen es sich um kapazitive Sensorelemente handelt. Die zugehörige Steuerung (Steuerelektronik) 4 befindet sich in einem Gehäuse 5, das rückseitig auf die Glasplatte 2 aufgeklebt ist.

Der Grundrahmen 1 wird an einer Wandöffnung befestigt, die in Überdeckung zu einer Revisionsöffnung eines Unterputz-Spülkastens liegt. Der Grundrahmen 1 besteht aus einem einteiligen Spritzgießteil, das vorzugsweise aus Kunststoff gefertigt ist. Er weist an seiner Vorderseite einen umlaufenden Flansch 1.1 auf, an dessen Innenkanten sich ein rückseitig vorstehender Kragen 1.2 anschließt. An dem Kragen 1.2 sind Halterungsstege 1.3 angeformt, die eine komplexe, dreidimensionale Form aufweisen. An parallel zu dem Flansch 1.1 angeordneten, gegenüber diesem zurückspringenden Stegabschnitten 1.4 sind Durchbrüche 1.5 zur Aufnahme von Schraubbolzen ausgebildet. Die Durchbrüche 1.5 sind etwa mittig der vertikalen Querseite des Grundrahmens 1 und in unmittelbarer Nähe des Kragens 1.2 angeordnet. Die in die Durchbrüche 1.5 einsetzbaren Schraubbolzen (nicht gezeigt) werden in einen Unterputz-Spülkasten oder eine vor dem Spülkasten angeordnete Wand eingeschraubt. Im montierten Zustand liegt die Rückseite des Flansches 1.1 an der Vorderseite einer die Revisionsöffnung des Unterputz-Spülkastens umgebenden Wandverkleidung, beispielsweise einem Fliesenbelag an.

Neben den Durchbrüchen 1.5 zur Aufnahme von Befestigungsschrauben weist der Grundrahmen 1 nahe den Innenecken seines Flansches 1.1 bzw. Kragens 1.2 Durchbrüche 1.6 und 1.7 zur lösbaren Befestigung des Befestigungselements 3 auf. Das Befestigungselement 3 ist als in den Grundrahmen 1 einsetzbarer Befestigungsrahmen ausgebildet. Es weist in einer Ebene angeordnete Flansche oder Stege 3.1 auf, an deren Rückseite den Durchbrüchen 1.6, 1.7 zugeordnete Clipelemente 3.2 sowie Zentrier- oder Führungselemente 3.3 ausgebildet sind. Die Zentrier- oder Führungselemente 3.3 haben die Form von kreiszylindrischen Bolzen oder Hülsen. Ihnen sind kreisförmige Ausnehmungen oder Durchbrüche 1.7 in den Stegabschnitten 1.3 des Grundrahmens 1 zugeordnet. Die bolzenförmigen Zentrier- oder Führungselemente 3.3 stehen an der Rückseite des Befestigungsrahmens 3 etwas weiter vor als die Clipelemente 3.2.

Die an dem Befestigungsrahmen 3 einteilig angeformten Clipelemente 3.2 bestehen aus federelastischen Rastzungen 3.21, 3.22. Je ein Paar der Rastzungen 3.21, 3.22, die zwischen sich einen Spalt begrenzen, wird in die im wesentlichen rechteckigen Durchbrüche 1.6 eingesteckt. Die Rastzungen 3.21, 3.22 weisen nasenförmige Vorsprünge 3.23, 3.24 auf, die an ihren Enden, dem Spalt abgewandt ausgebildet sind und im montierten Zustand des Befestigungsrahmens 3 gegenüberliegende Kanten des zugeordneten Durchbruchs 1.6 hintergreifen. Jeder der nasenförmigen Vorsprünge 3.23, 3.24 weist dabei zwei schräg verlaufende Flanken auf, von denen die eine Flanke zum freien Ende der Rastzunge 3.21 bzw. 3.22 hin abfällt, während die andere Flanke zum Steg des Befestigungsrahmens 3 hin abfällt.

Die Rastzungen 3.21, 3.22 und ihre Vorsprünge 3.23, 3.24 sind so bemessen und in Bezug auf die Kanten des zugeordneten Durchbruchs 1.6 angeordnet, dass die mit dem Befestigungsrahmen 3 hinterklebte Glasplatte 2 im montierten Zustand dicht und unter Spannung an dem Flansch 1.1 des Grundrahmens 1 anliegt.

Der Befestigungsrahmen 3 weist ferner einen bügelförmigen Mittelsteg 3.4 auf, der sowohl an dem rückseitig vorspringenden Kragen 3.5 als auch über Stegabschnitte 3.6 an den Stegen oder Flanschen 3.1 des Befestigungsrahmens 3 einteilig angeformt sind. Durch die Stegabschnitte 3.6 und den daran angeformten bügelförmigen Mittelsteg 3.4 besitzen die Flansche (Stege) 3.1 des Befestigungsrahmens 3 eine hohe Biegesteifigkeit. Die in einer gemeinsamen Ebene liegenden Vorderseiten der Flansche 3.1 sind mit der Rückseite 2.2 der Glasplatte 2 verklebt.

Das die Steuerung 4 beinhaltende Gehäuse 5 ist zwischen dem Kragen 3.5 und dem bügelförmigen Mittelsteg 3.4 des Befestigungsrahmens 3 angeordnet. Die Steuerung 4 ist mit einem Stromversorgungskabel 4.1 und einem Steuerleitungen enthaltenden Kabel 4.2 versehen, wobei letzteres mit einem Stellantrieb (nicht gezeigt) verbunden wird, der ein Ablaufventil des Spülkastens betätigt.

Die an der Steuerung 4 angeschlossenen Sensortasten sind in die mit der Glasplatte 2 verklebten Vorderseite 5.1 des Gehäuses 5 eingebettet.

Jede der beiden Sensortasten umfasst zwei metallisch leitende Schichten eines Kondensators, die voneinander getrennt und im wesentlich in der gleichen Ebene angeordnet sind. Die eine metallisch leitende Schicht des Kondensators ist dabei über eine Impedanz mit einem Impulsgenerator verbunden, der Rechteckimpulse abgibt. Die andere metallisch leitende Schicht des Kondensators ist über eine weitere Leitung mit einem Differential-Komparator verbunden. Ein weiterer Eingang des Komparators liegt an einer definierten Spannung. Am Ausgang des Komparators liegt eine Signalspannung einer bestimmten Form. Nähert sich nun ein Benutzer mit einem seiner Finger der jeweiligen Sensortaste, so ändert sich aufgrund der veränderten Verhältnisse (Kapazitanz) die Form des Signals am Ausgang des Komparators. Da der Komparator das Signal an seinem Eingang mit einer konstanten festen Bezugsspannung vergleicht, verändert sich bei Annäherung des Fingers des Benutzers an die Sensortaste die Impulsbreite der Impulszüge am Ausgang des Komparators. Bei Berühren der Glasplatte 2 vor der dahinter angeordneten Sensortaste werden die Impulse am Ausgang des Komparators schmaler. Die Änderung des Signals wird dann zur Auslösung eines Steuerungsvorgangs bzw. Spülvorgangs verwendet.

Auf der Vorderseite 2.1 der Glasplatte 2 sind Symbole 2.3, 2.4 angebracht oder aufgetragen, beispielsweise aufgedruckt, die für unterschiedliche Spülwassermengen oder Ablaufventil-Funktionen stehen. Die Sensortasten sind hinter den Symbolen 2.3, 2.4 an der Rückseite 2.2 der Glasplatte 2 angeordnet.

Die Steuerung 4 ist so ausgelegt, dass durch Annäherung oder Anordnung eines Fingers eines Benutzers an eine der beiden Sensortasten eine Vollspülung ausgelöst wird. Dieser Sensortaste ist das größere (2.3) der beiden Symbole auf der Vorderseite der Glasplatte 2 zugeordnet. Durch entsprechende Einwirkung auf die andere Sensortaste wird dagegen eine Teilspülung ausgelöst; dieser Sensortaste ist das kleinere Symbol 2.4 auf der Glasplatte 2 zugeordnet.

Die Steuerung 4 der erfindungsgemäßen Vorrichtung kann allerdings auch so ausgelegt sein oder wahlweise eingestellt werden, dass sie eine Spül-Stopp-Funktion ermöglicht. In diesem Fall wird durch Annäherung oder Anordnung eines Fingers eines Benutzers an eine der beiden Sensortasten ein Spülvorgang ausgelöst, und durch entsprechende Einwirkung auf die andere Sensortaste der Spülvorgang gestoppt.

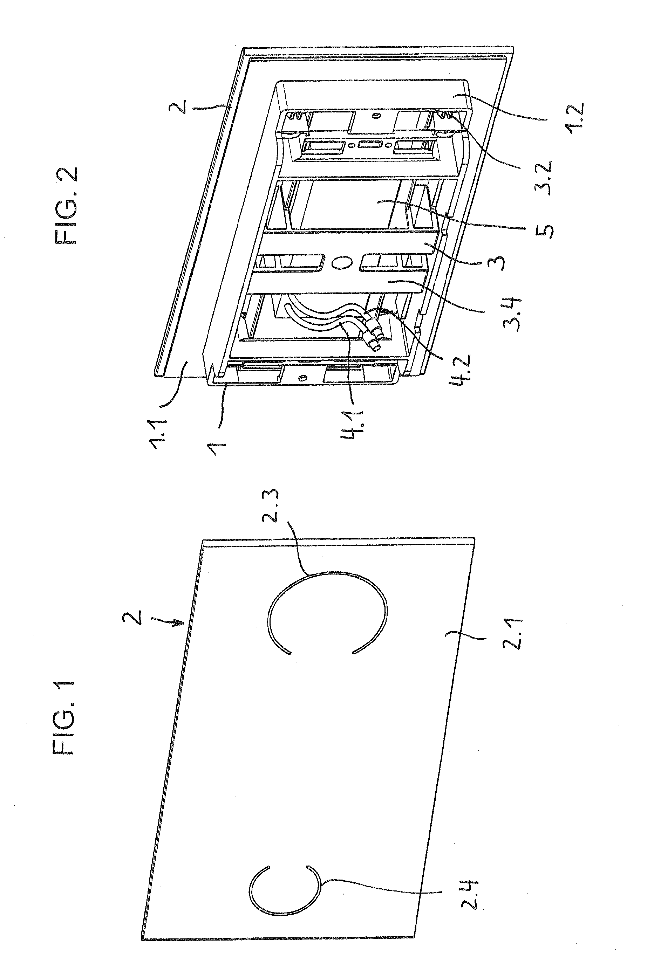

Der mit einer den Unterputz-Spülkasten enthaltenden Wand verschraubbare Grundrahmen 1 ist vorzugsweise verchromt oder silberfarben ausgebildet. Seine äußeren Abmessungen sind vorzugsweise nicht größer als die äußeren Abmessungen der Glasplatte 2. In dem dargestellten Ausführungsbeispiel überragt die rechteckige Glasplatte 2 im montierten Zustand seitlich geringfügig die äußeren Schmalseiten des Flansches 1.1 des Grundrahmens 1 (vgl. Fig. 2).

Wenn der Grundrahmen 1 an der Revisionsöffnung auf die Wandverkleidung aufgeschraubt ist, werden die Kabel 4.1, 4.2 der Steuerung 4 mit der Stromversorgung und dem Stellantrieb verbunden und anschließend die mit dem Befestigungsrahmen 3 hinterklebte Glasplatte 2 auf den Grundrahmen aufgeclipst. Der Grundrahmen 1 verbleibt als Sichtrahmen hinter der Glasplatte 2 auf der Wand.

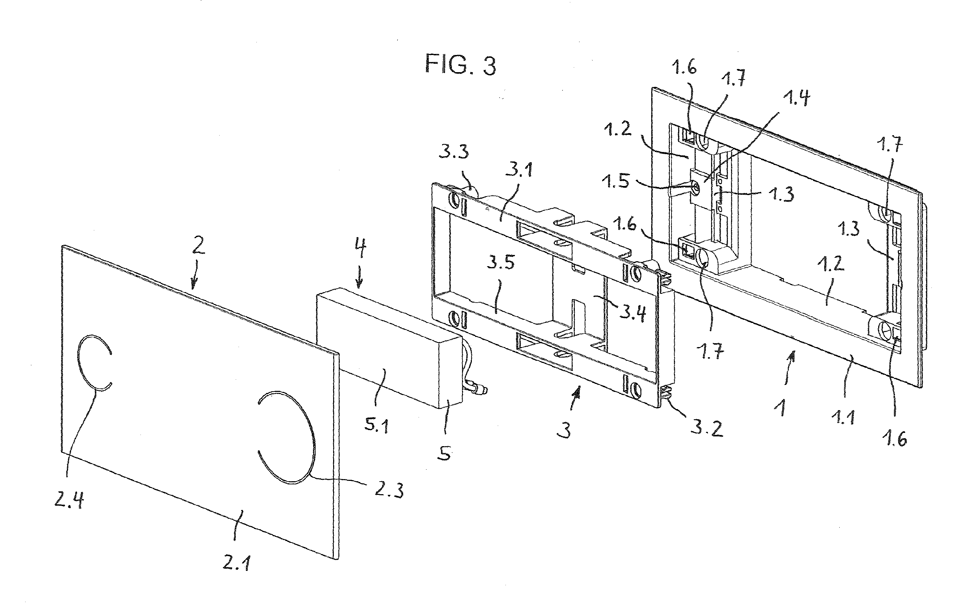

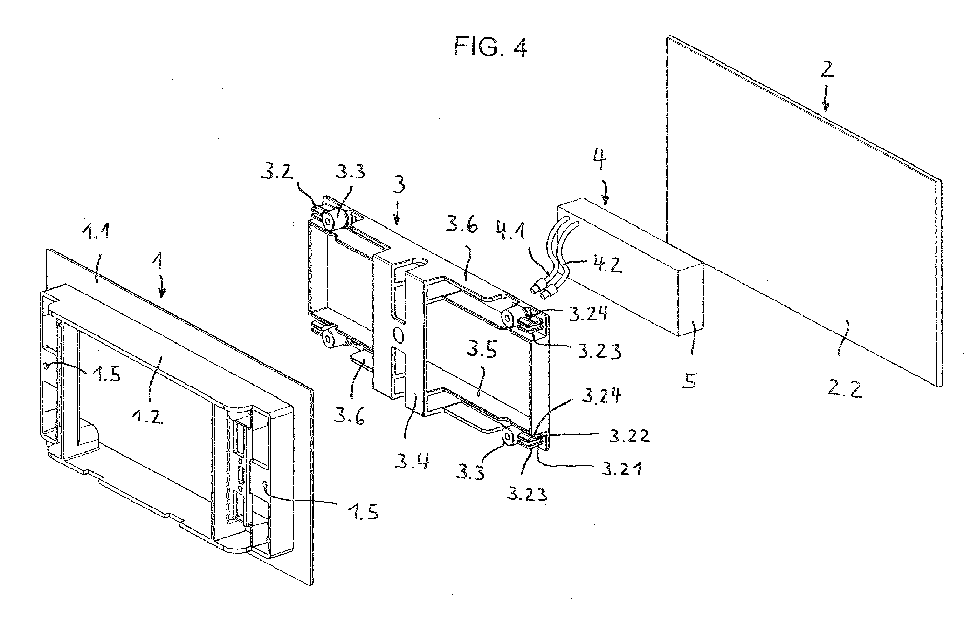

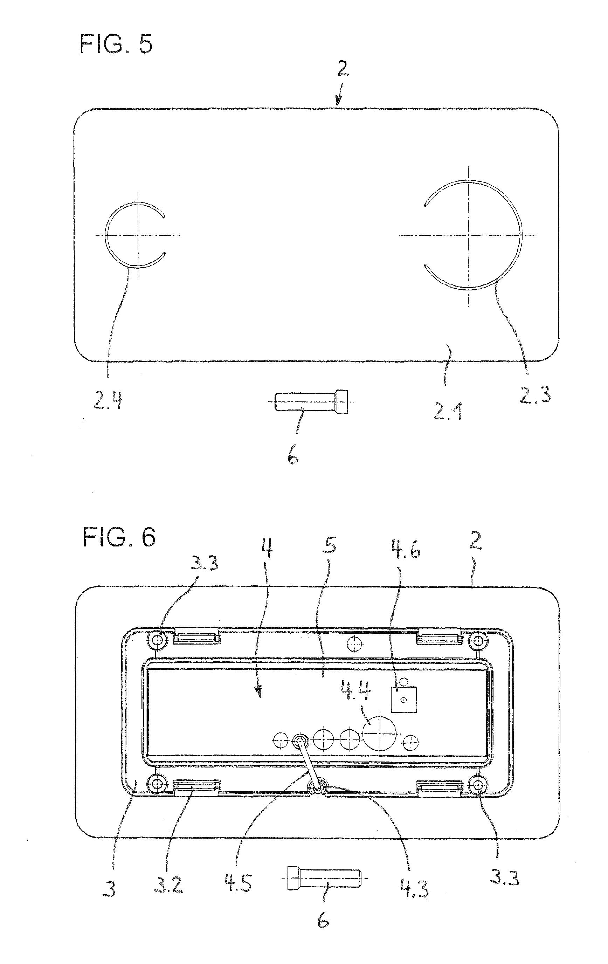

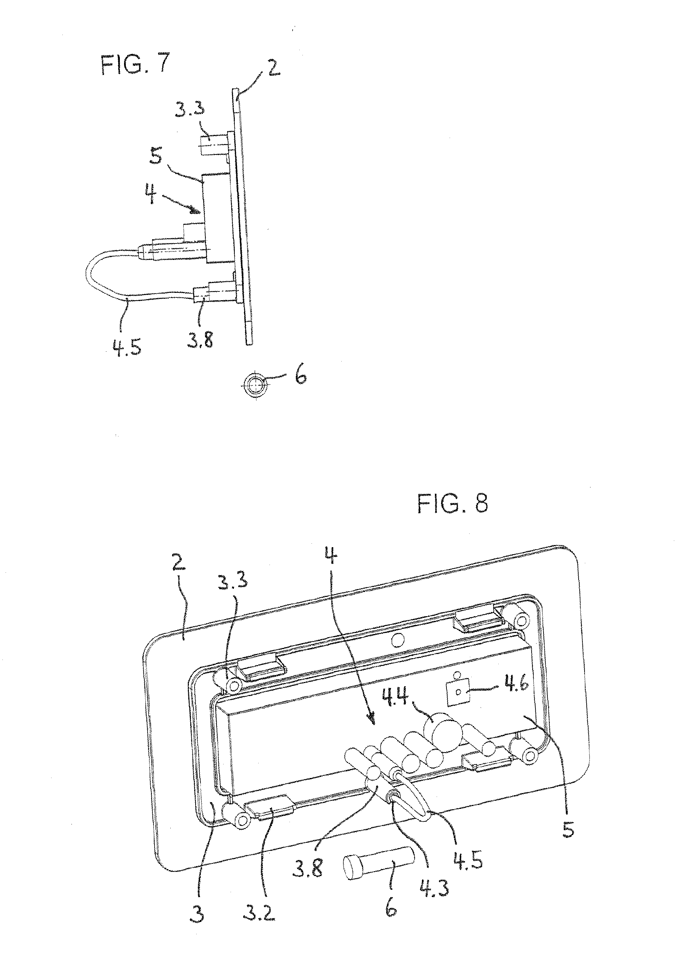

Die Funktionalität der Steuerung 4 gemäß den Figuren 2 bis 4 kann durch eine sehr nützliche Funktion ergänzt werden, wie nachfolgend unter Bezug auf die Figuren 5 bis 8 näher erläutert wird.

Die Figuren 5 bis 8 zeigen eine Betätigungsplatte 2, die wiederum aus Glas, vorzugsweise aus Sicherheitsglas hergestellt ist. Alternativ kann die Betätigungsplatte auch aus Kunststoff, insbesondere aus transparentem Kunststoff hergestellt sein. Die Betätigungsplatte 2 entspricht im Wesentlichen der in den Figuren 1, 3 und 4 dargestellten Betätigungsplatte 2. Die dargestellten Betätigungsplatten 2 unterscheiden sich im Wesentlichen nur hinsichtlich der Ausgestaltung ihrer Ecken; während die Ecken der Betätigungsplatte 2 gemäß Fig. 1 rechtwinklig ausgebildet sind, weist die Betätigungsplatte 2 gemäß Fig. 5 runde Ecken auf.

Um bei einer Reinigung der Betätigungsplatte 2 nicht unnötiger Weise eine oder mehrere Spülungen auszulösen, wurde bei der erfindungsgemäßen Vorrichtung eine "Reinigungsfunktion" realisiert.

Mittels eines Magnetschlüssels 6 und eines hinter der Betätigungsplatte 2 angeordneten Reed-Schalters 4.3 kann ein Anwender die Funktion der Sensortasten bzw. der Steuerung 4 zeitweise sperren, so dass dann bei einer Berührung der Betätigungsplatte 2 im Bereich der Sensortasten keine Spülung ausgelöst wird.

Hierzu ist dem Reed-Schalter 4.3 vorzugsweise ein Zeitglied 4.4 zugeordnet, das nach Ablauf einer definierten oder einstellbaren Zeitspanne die Sperrung (Deaktivierung) der Sensortaste oder der Steuerung 4 aufhebt. Der Anwender kann somit bei Bedarf die Steuerung 4 mittels des Magnetschlüssels 6 berührungslos für eine definierte Zeit in einen sogenannten "standby-Modus" (Wartemodus) versetzen. Der Warte- oder Deaktivierungsmodus kann automatisch ablaufen, so dass die Steuerung 4 nach Ablauf der definierten Zeit wieder aktiviert ist. Es ist jedoch auch möglich, die Steuerung 4 vor dem Ablauf der definierten Zeit manuell mittels des Magnetschlüssels 6 wieder zu aktivieren.

Die Betätigungsplatte 2 ist rückseitig mit einem Befestigungsrahmen (Halterahmen) 3 versehen. Der Befestigungsrahmen 3 ist vorzugsweise ein Kunststoffspritzgießteil und mit der Rückseite der Betätigungsplatte 2 verklebt. Innerhalb des Befestigungsrahmens 3 ist das die Steuerung (Steuerelektronik) 4 enthaltende Gehäuse 5 angeordnet, das ebenfalls rückseitig auf die Betätigungsplatte 2 aufgeklebt ist.

Der Befestigungsrahmen 3 weist in der Mitte seines unteren Abschnitts eine Halterung 3.8 für den Reed-Schalter 4.3 auf. Von dem Schalter 4.3 führt eine Verbindungsleitung (Signalleitung) 4.5 zur Steuerelektronik 4. Dem Reed-Schalter 4.3 ist ein akustischer Signalgeber 4.6 zugeordnet, der bei einer Deaktivierung der Steuerung 4 den Warte- oder Deaktivierungsmodus dauerhaft oder intermittierend durch ein entsprechendes Signal signalisiert.

## Patentansprüche

1. Vorrichtung zur elektrischen Auslösung eines Spülvorgangs in einer sanitären Einrichtung, insbesondere in einem WC oder Urinal, mit einer Betätigungsplatte (2) aus Glas oder aus einem anderen elektrisch nicht-leitfähigem Material, wobei die Betätigungsplatte (2) mindestens eine Sensortaste aufweist, die an einer Steuerung (4) zur Betätigung eines Ablauf- oder Wasserventils angeschlossen ist,
**dadurch gekennzeichnet, dass** die Betätigungsplatte (2) mit mindestens einem berührungslos betätigbaren Schalter (4.3) versehen ist, mittels dem die Sensortaste oder die Steuerung (4) deaktivierbar ist.

2. Vorrichtung nach Anspruch 1,
**dadurch gekennzeichnet, dass** dem Schalter (4.3) ein Zeitglied (4.4) zugeordnet ist, das nach Ablauf einer vorgegebenen oder vorgebbaren Zeitspanne die durch Betätigung des Schalters (4.3) bewirkte Deaktivierung der Sensortaste oder der Steuerung (4) automatisch aufhebt.

3. Vorrichtung nach Anspruch 1 oder 2,
**dadurch gekennzeichnet, dass** der Schalter (4.3) als Ein-Aus-Schalter ausgeführt ist, so dass die Sensortaste oder die Steuerung (4) deaktivierbar und eine solche Deaktivierung unverzüglich wieder aufhebbar ist.

4. Vorrichtung nach einem der Ansprüche 1 bis 3,
**dadurch gekennzeichnet, dass** dem Schalter (4.3) ein Signalgeber (4.6) zugeordnet ist, der während der Deaktivierung der Sensortaste oder der Steuerung (4) ein akustisches und/oder optisches Signal abgibt.

5. Vorrichtung nach einem der Ansprüche 1 bis 4,
**dadurch gekennzeichnet, dass** der Schalter (4.3) aus einem magnetischen Näherungsschalter gebildet ist, der berührungslos mittels eines Magneten betätigbar ist.

6. Vorrichtung nach einem der Ansprüche 1 bis 5,
**dadurch gekennzeichnet, dass** der Schalter (4.3) an der Hinterseite der Betätigungsplatte (2) angeordnet ist, so dass er nach bestimmungsgemäßer Montage der Betätigungsplatte (2) für einen Benutzer unsichtbar ist.

7. Vorrichtung nach einem der Ansprüche 1 bis 6,
**dadurch gekennzeichnet, dass** die Betätigungsplatte (2) mit mindestens zwei an der Steuerung (4) angeschlossenen Sensortasten versehen ist, wobei der jeweiligen Sensortaste ein auf der Vorderseite (2.1) der Betätigungsplatte (2) angeordnetes Symbol (2.3, 2.4) zugeordnet ist.

8. Vorrichtung nach Anspruch 7,
**dadurch gekennzeichnet, dass** eine der Sensortasten einer Vollspülung und eine andere der Sensortasten einer Teilspülung zugeordnet ist.

9. Vorrichtung nach Anspruch 7,
**dadurch gekennzeichnet, dass** eine der Sensortasten einer Spülstopp-Funktion zugeordnet ist.

10. Vorrichtung nach einem der Ansprüche 1 bis 9,
**dadurch gekennzeichnet, dass** die Betätigungsplatte (2) aus Sicherheitsglas hergestellt ist.

11. Vorrichtung nach einem der Ansprüche 1 bis 10,
**dadurch gekennzeichnet, dass** die mindestens eine Sensortaste und/oder ein die Steuerung (4) beinhaltendes Gehäuse (5) auf die Rückseite (2.2) der Betätigungsplatte (2) aufgeklebt sind.

12. Vorrichtung nach einem der Ansprüche 1 bis 11,
**dadurch gekennzeichnet, dass** die Betätigungsplatte (2) eine fugenlos sowie ohne sonstigen Durchbruch ausgebildete Vorderseite besitzt.

13. Vorrichtung nach einem der Ansprüche 1 bis 12,
**dadurch gekennzeichnet, dass** die mindestens eine Sensortaste ausschließlich auf der Rückseite der Betätigungsplatte (2) angeordnet ist.

14. Vorrichtung nach einem der Ansprüche 1 bis 13,
**dadurch gekennzeichnet, dass** die Betätigungsplatte (2) rückseitig mit einem Grundrahmen
(1) versehen ist, mittels dem sie an einer Revisionsöffnung eines Unterputz-Spülkastens oder einer Wandöffnung befestigbar ist, wobei die Betätigungsplatte
(2) im montierten Zustand die Wandöffnung oder Revisionsöffnung abdeckt.

15. Vorrichtung nach Anspruch 14,
**dadurch gekennzeichnet, dass** die Betätigungsplatte (2) rückseitig mindestens ein mit dem Grundrahmen (1) lösbar verbindbares Befestigungselement (3) aufweist, wobei das Befestigungselement (3) und/oder der Grundrahmen (1) mit einteilig angeformten Clipelementen (3.2) versehen ist.
